# EUROPEAN PATENT SPECIFICATION

(11) **EP 1 771 860 B1**
(45) Date of publication and mention of the grant of the patent: **30.09.2009**
(21) Application number: 05760030.6
(22) Date of filing: 12.07.2005
(51) Int. Cl.: G11C 13/04, G11B 7/24

(54) **INFORMATION CARRIER, SYSTEM AND APPARATUS FOR READING SUCH AN INFORMATION CARRIER**
INFORMATIONSTRÄGER SOWIE SYSTEM UND VERFAHREN ZUM LESEN EINES DERARTIGEN INFORMATIONSTRÄGERS
SUPPORT D'INFORMATIONS, SYSTEME ET APPAREIL PERMETTANT DE LIRE CE SUPPORT D'INFORMATIONS

(30) Priority: 21.07.2004 EP 04300456
(43) Date of publication of application: 11.04.2007
(73) Proprietor: Koninklijke Philips Electronics N.V., 5621 BA Eindhoven (NL)
(72) Inventor: HENDRIKS, Robert, Société Civile SPID, F-75008 PARIS (FR); BAKKER, Levinus, Société Civile SPID, F-75008 PARIS (FR)
(74) Representative: Uittenbogaard, Frank
(86) International application number: PCT/IB2005/052307
(87) International publication number: WO 2006/011087

(56) References cited:
- WO-A-20/04057622
- WO-A-20/05027104
- WO-A-20/05027108
- WO-A-20/05045817
- US-A- 6 052 354
- US-A- 6 094 413
- US-B1- 6 459 659
- US-B1- 6 485 413
- PATENT ABSTRACTS OF JAPAN vol. 1998, no. 02, 30 January 1998 (1998-01-30) -& JP 09 258007 A (VICTOR CO OF JAPAN LTD), 3 October 1997 (1997-10-03)

## Description

### FIELD OF THE INVENTION

The invention relates to an information carrier having a new structure.

The invention also relates to a system for reading such an information carrier.

The invention also relates to various apparatus including such a reading system.

The invention has applications in the field of optical data storage.

### BACKGROUND OF THE INVENTION

The use of optical storage solutions is nowadays widespread for content distribution, for example in storage systems based on the DVD (Digital Versatile Disc) standards. Optical storage has a big advantage over hard-disc and solid-state storage in that the information carrier are easy and cheap to replicate.

However, due to the large amount of moving elements in the drives, known applications using optical storage solutions are not robust to shocks when performing read/write operations, considering the required stability of said moving elements during such operations. As a consequence, optical storage solutions cannot easily and efficiently be used in applications which are subject to shocks, such as in portable devices.

Recently, optical storage solutions have thus been developed. These solutions combine the advantages of optical storage in that a cheap and removable information carrier ism used, and the advantages of solid-state storage in that the information carrier is still and that its reading requires a limited number of moving elements.

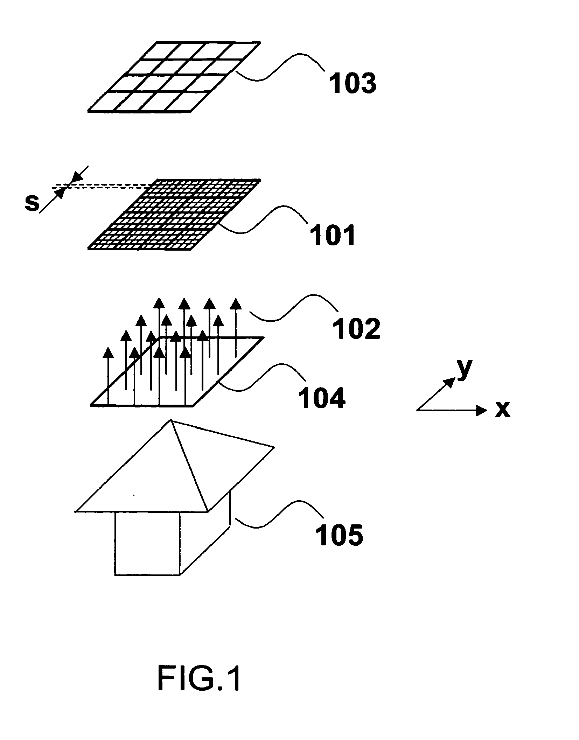

Fig.1 depicts a three-dimensional view of system illustrating such an optical storage solution.

This system is disclosed in the not prepublished document WO-A1-2005 027108 which falls under the Article 54(3) EPC.

This system comprises an information carrier 101. The information carrier 101 comprises a set of square adjacent elementary data areas having size referred to as s and arranged as in a matrix. Data are coded on each elementary data area via the use of a material intended to take different transparency levels, for example two levels in using a material being transparent or non-transparent for coding a 2-states data, or more generally N transparency levels (for example N being an integer power of 2 for coding a ²log(N)-states data).

This system also comprises an optical element 104 for generating an array of light spots 102 which are intended to be applied to said elementary data areas.

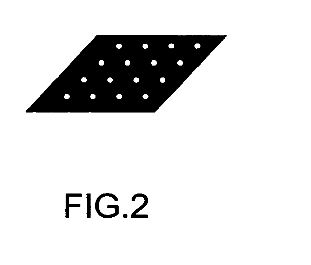

The optical element 104 may correspond to a two-dimensional array of apertures at the input of which the coherent input light beam 105 is applied. Such an array of apertures is illustrated in Fig.2. The apertures correspond for example to circular holes having a diameter of 1 µm or much smaller.

The array of light spots 102 is generated by the array of apertures in exploiting the Talbot effect which is a diffraction phenomenon working as follows. When a coherent light beam, such as the input light beam 105, is applied to an object having a periodic diffractive structure (thus forming light emitters), such as the array of apertures, the diffracted lights recombines into identical images of the emitters at a plane located at a predictable distance z0 from the diffracting structure. This distance z0 is known as the Talbot distance. The Talbot distance z0 is given by the relation z0 = 2.n.d² / λ, where d is the periodic spacing of the light emitters, λ is the wavelength of the input light beam, and n is the refractive index of the propagation space. More generally, re-imaging takes place at other distances z(m) spaced further from the emitters and which are a multiple of the Talbot distance z such that z(m) = 2.n.m.d² / λ, where m is an integer. Such a re-imaging also takes place for m = ½ + an integer, but here the image is shifted over half a period. The re-imaging also takes place for m = ¼ + an integer, and for m =¾ + an integer, but the image has a doubled frequency which means that the period of the light spots is halved with respect to that of the array of apertures.

Exploiting the Talbot effect allows generating an array of light spots of high quality at a relatively large distance from the array of apertures (a few hundreds of µm, expressed by z(m)), without the need of optical lenses. This allows inserting for example a cover layer between the array of aperture and the information carrier 201 for preventing the latter from contamination (e.g. dust, finger prints ...). Moreover, this facilitates the implementation and allows increasing in a cost-effective manner, compared to the use of an array of micro-lenses, the density of light spots which are applied to the information carrier.

Each light spot is intended to be successively applied to an elementary data area. According to the transparency state of said elementary data areas, the light spot is transmitted (not at all, partially or fully) to a CMOS or CCD detector 103 comprising pixels intended to convert the received light signal, so as to recover the data stores on said elementary data area.

Advantageously, one pixel of the detector is intended to detect a set of elementary data, said set of elementary data being arranged in a so-called macro-cell data, each elementary data area among this macro-cell data being successively read by a single light spot of said array of light spots 102. This way of reading data on the information carrier 101 is called macro-cell scanning in the following and will be described after.

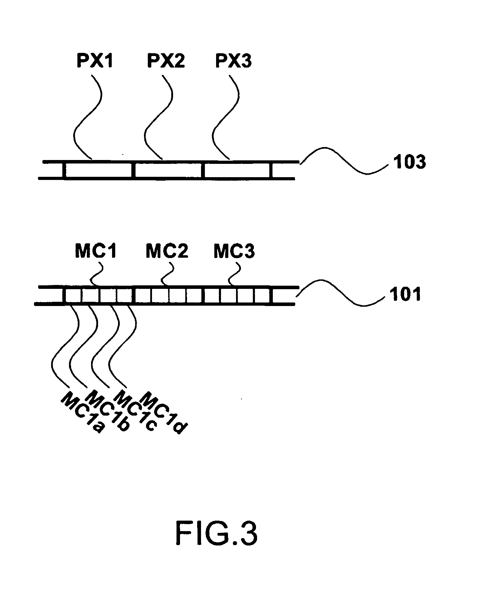

Fig.3 depicts a partial cross-section and detailed view of the information carrier 101, and of the detector 103.

The detector 103 comprises pixels referred to as PX1-PX2-PX3, the number of pixels shown being limited for facilitating the understanding. In particular, pixel PX1 is intended to detect data stored on the macro-cell data MC1 of the information carrier, pixel PX2 is intended to detect data stored on the macro-cell data MC2, and pixel PX3 is intended to detect data stored on the macro-cell data MC3. Each macro-cell data comprises a set of elementary data. For example, macro-cell data MC1 comprises elementary data referred to as MC1a-MC1b-MC1c-MC1d.

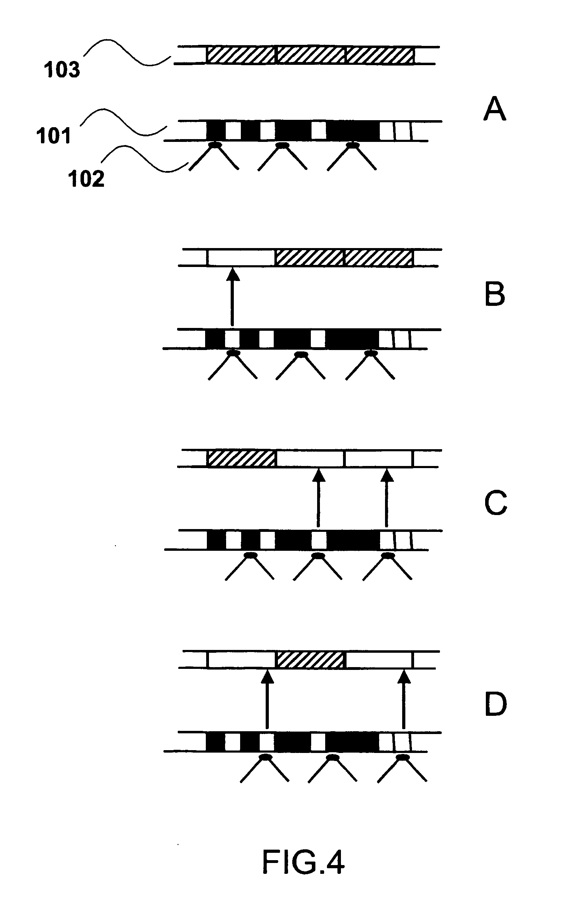

Fig.4 illustrates by an example the macro-cell scanning of the information carrier 101. For facilitating the understanding, only 2-states data are considered, similar explanations holding for an N-state coding. Data stored on the information carrier have two states indicated either by a black area (i.e. non-transparent) or white area (i.e. transparent). For example, a black area corresponds to a "0" binary state while a white area corresponds to a "1" binary state.

When a pixel of the detector 103 is illuminated by an output light beam generated by the information carrier 101, the pixel is represented by a white area. In that case, the pixel delivers an electric output signal (not represented) having a first state. On the contrary, when a pixel of the detector 103 does not receive any output light beam from the information carrier, the pixel is represented by a cross-hatched area. In that case, the pixel delivers an electric output signal (not represented) having a second state.

In this example, each macro-cell data comprises four elementary data areas, and a single light spot is applied simultaneously to each set of data. The scanning of the information carrier 101 by the array of light spots 102 is performed for example from left to right, with an incremental lateral displacement which equals the period of the elementary data areas.

In position A, all the light spots are applied to non-transparent areas so that all pixels of the detector are in the second state.

In position B, after displacement of the light spots to the right, the light spot to the left side is applied to a transparent area so that the corresponding pixel is in the first state, while the two other light spots are applied to non-transparent areas so that the two corresponding pixels of the detector are in the second state.

In position C, after displacement of the light spots to the right, the light spot to the left side is applied to a non-transparent area so that the corresponding pixel is in the second state, while the two other light spots are applied to transparent areas so that the two corresponding pixels of the detector are in the first state.

In position D, after displacement of the light spots to the right, the central light spot is applied to a non-transparent area so that the corresponding pixel is in the second state, while the two other light spots are applied to transparent areas so that the two corresponding pixels of the detector are in the first state.

Elementary data which compose a macro-cell opposite a pixel of the detector are read successively by a single light spot. The scanning of the information carrier 101 is complete when the light spots have each been applied to all elementary data area of a macro-cell data facing a pixel of the detector. This implies a two-dimensional scanning of the information carrier.

To read the information carrier, a scanning of the information carrier by the array of light spots is done in a plane parallel to the information carrier. A scanning device provides translational movement of the light spots in the two directions x and y for scanning all the surface of the information carrier.

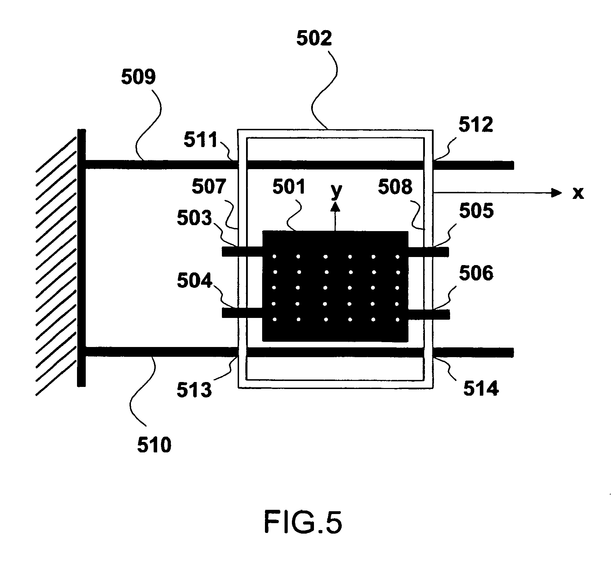

In a first solution depicted in Fig. 5, the scanning device corresponds to an H-bridge. The optical element generating the array of light spots (i.e. the array of micro-lenses or the array of apertures) is implemented in a first sledge 501 which is movable along the y axis compared to a second sledge 502. To this end, the first sledge 501 comprises joints 503-504-505-506 in contact with guides 507-508. The second sledge 502 is movable along the x axis by means of joints 511-512-513-514 in contact with guides 509-510. The sledges 501 and 502 are translated by means of actuators (not represented), such as by step-by-step motors, magnetic or piezoelectric actuators acting as jacks.

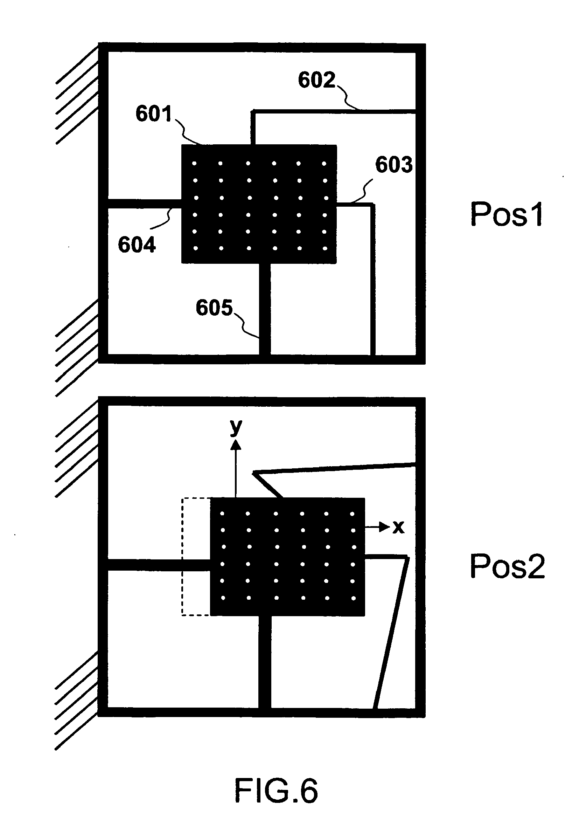

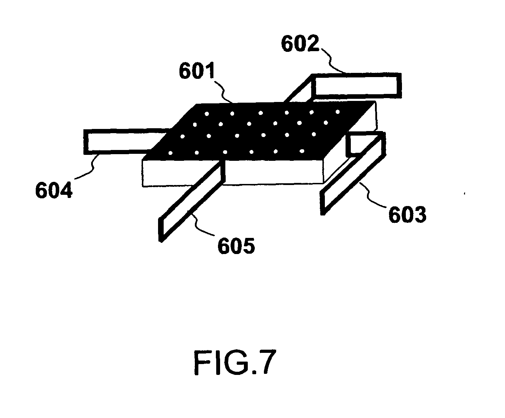

In a second solution depicted in Fig.6, the scanning device is maintained in a frame 601. The elements used for suspending the frame 601 are depicted in a detailed three-dimensional view in Fig.7. These elements comprise:
- a first leaf spring 602,
- a second leaf spring 603,
- a first piezoelectric element 604 providing the actuation of the scanning device 601 along the x axis,
- a second piezoelectric element 605 providing the actuation of the scanning device 601 along the y axis.

The second solution depicted in Fig.6 has less mechanical transmissions than the H-bridge solution depicted in Fig.5. The piezoelectric elements, in contact with the frame 601, are electrically controlled (not represented) so that a voltage variation results in a dimension change of the piezoelectric elements, leading to a displacement of the frame 601 along the x and/or the y axis.

The position Pos1 depicts the scanning device 601 in a first position, while the position Pos2 depicts the scanning device 601 in a second position after translation along the x axis. The flexibility of the leaf springs 602 and 603 is put in evidence.

A similar configuration can be built with four piezoelectric elements, the two extra piezoelectric elements replacing the leaf springs 602 and 603. In that case, opposite pair of piezoelectric elements act together in one dimension in the same way as an antagonist pair of muscles.

Such an information carrier and reading system suffer however from limitations.

Firstly, the plan of the scanning device which embed the array of apertures must be permanently parallel to the plane of the information carrier so that the light spots are applied accurately to the elementary data areas. Since, the scanning device is moving, this condition may often not be respected, for example because of shocks. This leads to errors in the data recovery.

Secondly, according to temperature variation, the shape of the scanning device and/or the information carrier may change, resulting in a difference between the period of the light spots and the period of the elementary data areas. This also leads to errors in the data recovery.

Finally, the use of such a scanning device still requires a lot of moving elements which avoids its implementation in a reading apparatus of reduced size.

The document US-B1-6 459 659 discloses the preamble of the claim 1.

### OBJECT AND SUMMARY OF THE INVENTION

It is an object of the invention to propose an information carrier which improves data recovery and can be read in a reading apparatus, which is more compact.

To this end, the information carrier according to the invention comprises the features of claim 1.

Contrary to the prior art where the array of apertures is integrated in the reader apparatus, the array of apertures is now integrated in a same package with the data layer. Since this assembling is done during manufacturing, it can be assumed that parallelism between the array of apertures and the data layer is guarantied.

Since the array of apertures is now integrated in a same package with the data layer, a change of size of this information carrier, for example caused by a temperature change and/or a mechanical constraint, will imply the same change of size on the array of apertures and on the data layer. As a consequence, this information carrier is more robust to deformation.

The invention also relates to a system for reading an information carrier according to claim 1, said system comprising the features of claim 4.

This information carrier remains still very thin, which allows to significantly reduce the size of such a system in charge of reading this information carrier.

In a preferred embodiment, the system according to the invention comprises an actuator for varying the angle of said output laser beam.

Varying the angle of the laser beam allows to shift laterally the array of light spots applied to the data layer in a cost-effective manner and in using a minimum of moving elements. Such a scanning may be used in the case where the information carrier comprises data arranged according to macro-cells.

In a preferred embodiment, the system according to the invention comprises a phase shifter for linearly varying the phase of said output laser beam.

Varying the phase of the laser beam allows to shift laterally the array of light spots applied to the data layer in a cost-effective manner without using moving elements. Such a scanning may be used in the case where the information carrier comprises data arranged according to macro-cells.

In a preferred embodiment, the light source comprises a modulator for varying the wavelength of said output laser beam.

Slightly varying the wavelength of the laser beam allows to easily tune the focusing of the light spots on the information carrier so that the data recovery is improved.

The invention also relates to various reading apparatus implementing such a system.

Detailed explanations and other aspects of the invention will be given below.

### BRIEF DESCRIPTION OF THE DRAWINGS

The particular aspects of the invention will now be explained with reference to the embodiments described hereinafter and considered in connection with the accompanying drawings :
Fig.1 depicts a system for reading an information carrier,
Fig.2 depicts an optical element dedicated to generate an array of light spots,
Fig.3 depicts a detailed view of said system for reading an information carrier,
Fig.4 illustrates by an example the principle of macro-cell scanning of an information carrier,
Fig.5 depicts a first arrangement for scanning an information carrier,
Fig.6 depicts a second arrangement for scanning an information carrier,
Fig.7 depicts detailed elements of said second arrangement,
Fig.8 depicts an information carrier according to the invention,
Fig.9 depicts a first system for reading an information carrier according to the invention,
Fig.10 depicts a second system for reading an information carrier according to the invention,
Fig.11 illustrates various apparatus and devices comprising a system for reading an information carrier according to the invention.

### DETAILED DESCRIPTION OF THE INVENTION

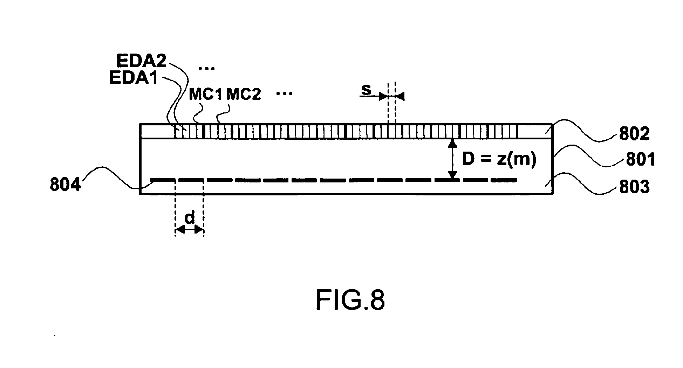

Fig.8 depicts an information carrier 801 according to the invention. This information carrier 801 comprises :
- a data layer 802 intended to store a set of elementary data,
- a layer 803 comprising an array of apertures 804 placed parallel to said data layer 802 for generating an array of light spots intended to be applied to said data layer. The array of apertures exploits the Talbot-effect described previously. The layer 803 is for example made of a transparent material such as plastic or resin in which the array of apertures is included.

The data layer 802 and the layer 803 are stacked and assembled so as to form a single package.

The distance D between the data layer 802 and the array of apertures 803 is equal to a multiple or a sub multiple of the Talbot distance z0. As described previously, this distance D is such that D = z(m) = 2.n.m.d² / λ, where n is the refractive index of the propagation space, m is a multiple or a sub multiple, d is the periodic spacing (i.e. the period) of the apertures, λ is the wavelength of the input light beam intended to be applied to the array of apertures.

To store data, the information carrier may comprise adjacent elementary data areas (EDA1, EDA2...) as depicted according to the prior art. Data may be arranged according to macro-cells (MC1, MC2 ... illustrated by rectangles in bold), so that in that case the period d of the apertures is a multiple of the period s of the elementary data areas.

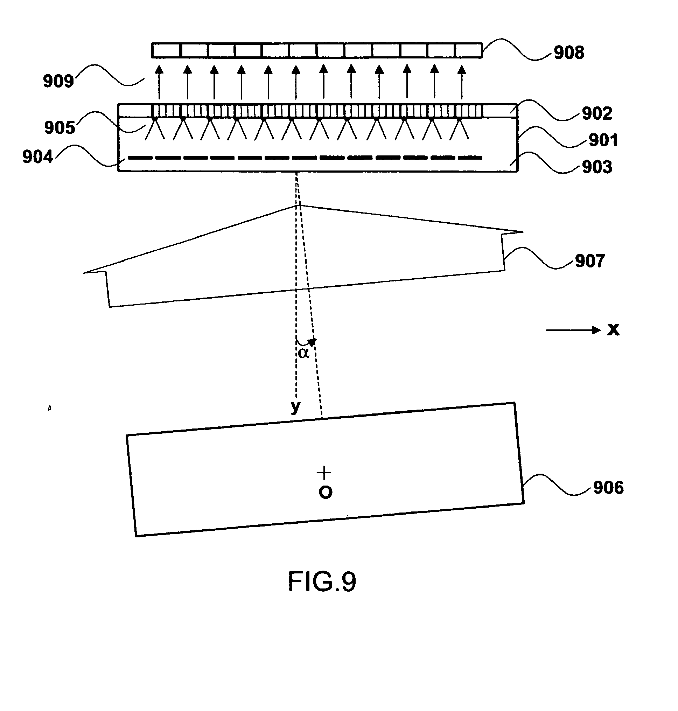

Fig.9 depicts a system for reading an information carrier 901 according to the invention. The information carrier comprises :
- a data layer 902 intended to store a set of elementary data,
- a layer 903 comprising an array of apertures 904 placed parallel to said data layer 902 for generating an array of light spots 905 intended to be applied to said data layer.

This system comprises a light source 906 for generating an output laser beam 907 intended to be applied to all the surface of said array holographic layer 903. The output laser beam 907 has a two-dimensional section. The shape of this section is preferably the same as the shape of the holographic layer 903 (and also that of the information carrier), i.e. square or rectangular.

To detect the data which are stored on the data layer 902, a detector 908 (for example a CMOS detector) is placed parallel to the information carrier 901. The detector 908 is in charge of detecting the level of the output light signals 909 generated at the output of the data layer 902 in response of the light spots 905. The principle of data detection is the same as the one described in the prior art section.

Advantageously, the system also comprises an actuator for varying the angle α (compared to a direction y perpendicular to the surface of the information carrier) of said expanded laser beam 909. Indeed, varying the angle α results in a phase shift of the laser beam at the input of the array of apertures 904, said phase shift varying linearly along the x direction. It can be shown that if such a linear phase shift is created, the pattern created by the Talbot effect by the array of apertures 904 is laterally and linearly shifted along the x direction. In other words, the angle α and the lateral position of the light spots 905 are linked by a linear relation, which allows to easily scan the light spots at the surface of the data layer 902. This shift is in particular useful when data are arranged according to macro-cells (illustrated by rectangles in bold in the data layer) so that a given light spot can be successively shifted in front of each elementary data area forming of a given macro-cell. The angle α may be varied mechanically by an actuator corresponding for example to a step by step motor (not shown) in charge of rotating the light source 906 around the point O.

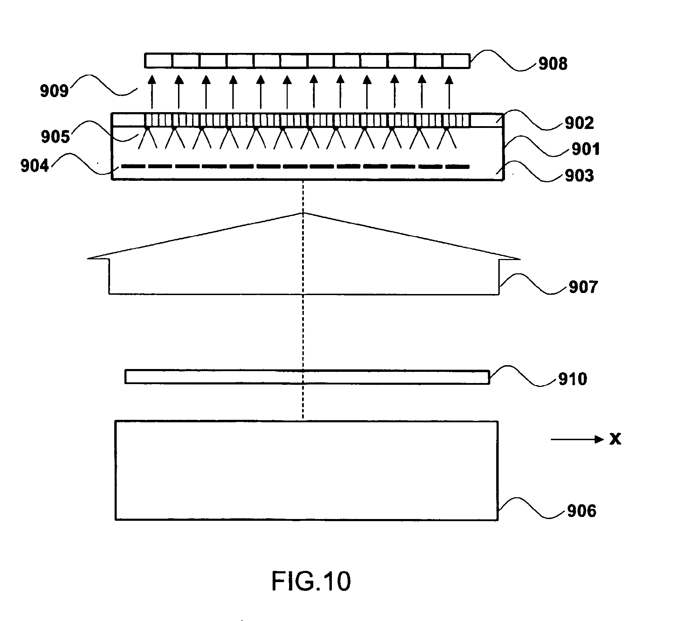

Alternatively, as depicted in Fig.10, instead of varying the angle α by an actuator, the system comprises a phase shifter 910 placed at the output of the light source 906. For example, the phase shifter 910 may correspond to a Liquid Crystal (LC) deflector placed on the optical path of the beam generated by the light source 906, and imposing a phase shift varying linearly along axis x, a change of the linearity coefficient allowing to vary the lateral position of the array of light spots 905.

Advantageously, the light source 906 also comprises a modulator (not shown) for varying the wavelength λ of said output laser beam 907. Indeed, since the light spots 905 appear at the Talbot distance z0 (or at a multiple or a sub-multiple of the Talbot distance z0), and considering that the Talbot distance is expressed as a function of the wavelength λ of the output laser beam, a slight variation of the wavelength λ may be used to accurately focus the light spots 905 at the surface of the data layer 902.

For example, solutions known by skilled persons can be used to modulate the wavelength of the light source 906, such as using a distributed feedback (DFB) laser source, or an external cavity laser (ECL) using a grating which is tilted so that a different wavelength is returned to the laser cavity.

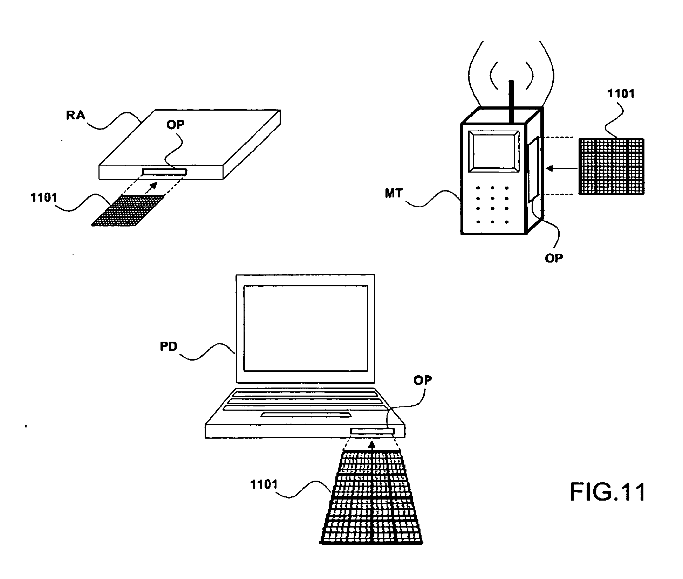

As illustrated in Fig.11, the system according to the invention may advantageously be implemented in a reading apparatus RA (e.g. home player apparatus ...), a portable device PD (e.g. portable digital assistant, portable computer, a game player unit...), or a mobile telephone MT. These apparatus and devices comprise an opening (OP) intended to receive an information carrier 1101 as depicted by Fig.8, and a system as depicted by Fig.9 or Fig.10 in view of recovering data stored on said information carrier.

The verb "comprise" does not exclude the presence of other elements than those listed in the claims.

## Claims

1. An information carrier (801) comprising :
- a data layer (802) intended to store a set of elementary data,
- a layer (803) comprising a periodic array of apertures (804) placed parallel to said data layer (802) for generating an array of light spots intended to be applied to said data layer (802), **characterized in that** the distance between the data layer and the layer is equal to a multiple or a sub multiple of the Talbot distance.

2. An information carrier as claimed in claim 1, further comprising adjacent elementary data areas (EDA1, EDA2...) intended to store said elementary data.

3. An information carrier as claimed in claim 1 or 2, wherein the period (d) of the apertures is a multiple of the period (s) of the elementary data areas (EDA1, EDA2...).

4. A system for reading an information carrier having a data layer and a layer (803) comprising a periodic array of apertures (804) placed parallel to said data layer (802) for generating an array of light spots intended to be applied to said data layer (802), the distance between the data layer and the layer being equal to a multiple or a sub multiple of the Talbot distance, said system comprising :
- a light source (906) for generating an output laser beam (907) intended to be applied to all the surface of said layer, said output laser beam having a two-dimensional square or rectangular section,
- a detector (908) for detecting output light signals generated at the output of said data layer in response of said output laser beam (907).

5. A system as claimed in claim 4, further comprising an actuator for varying the angle (α) of said output laser beam (907).

6. A system as claimed in claim 4, further comprising a phase shifter (910) for varying the phase of said output laser beam (907).

7. A system as claimed in claim 4, 5 or 6, wherein said light source (906) comprises a modulator for varying the wavelength of said output laser beam (907).

8. A portable device comprising a system as claimed in claim 4, 5, 6 or 7.

9. A mobile telephone comprising a system as claimed in claim 4, 5, 6 or 7.

10. A game player unit comprising a system as claimed in claim 4, 5, 6 or 7.

## Patentansprüche

1. Informationsträger (801), der Folgendes umfasst:
- eine Datenschicht (802) zur Speicherung eines Satzes elementarer Daten,
- eine Schicht (803) mit einer periodischen Anordnung von Öffnungen (804), die parallel zu der genannten Datenschicht vorgesehen ist zur Erzeugung einer Reihe von Lichtpunkten zur Zuführung zu der genannten Datenschicht (802), **dadurch gekennzeichnet, dass** der Abstand zwischen der Datenschicht und der Schicht einem Vielfachen oder einem echten Vielfachen des Talbot-Abstandes entspricht.

2. Informationsträger nach Anspruch 1, wobei dieser Informationsträger weiterhin nebeneinander liegende Elementardatengebiete (edel, EDA2,...) zur Speicherung der genannten Elementardaten aufweist.

3. Informationsträger nach Anspruch 1 oder 2, wobei die Periode (d) der Öffnungen ein Vielfaches der Periode (s) der Elementardatengebiete (EDA1, EDA2,...) ist.

4. System zum Auslesen eines Informationsträgers mit einer Datenschicht und einer Schicht (803) mit einer periodischen Anordnung von Öffnungen (804), die parallel zu der genannten Datenschicht (802) vorgesehen ist zur Erzeugung einer Reihe von Lichtpunkten zur Zuführung zu der genannten Datenschicht (802), wobei der Abstand zwischen der Datenschicht und der Schicht einem Vielfachen oder einem echten Vielfachen des Talbot-Abstandes entspricht, wobei das genannte System Folgendes umfasst:
- eine Lichtquelle (906) zum Erzeugen eines Ausgangslaserbündels (907) zur Zuführung zu der ganzen Oberfläche der genannten Schicht, wobei das genannte Ausgangslaserbündel einen zweidimensionalen quadratischen oder rechteckigen Querschnitt hat,
- einen Detektor (908) zum Detektieren von Ausgangslichtsignalen, erzeugt am Ausgang der genannten Datenschicht in Reaktion auf das genannte Ausgangslaserbündel (907).

5. System nach Anspruch 4, das weiterhin ein Stellglied zum Variieren des Winkels (α) des genannten Ausgangslaserbündels (907) aufweist.

6. System nach Anspruch 4, das weiterhin einen Phasenschieber (910) zum Variieren der Phase des genannten Ausgangslaserbündels (907) aufweist.

7. System nach Anspruch 4, 5 oder 6, wobei die genannte Lichtquelle (906) einen Modulator zum Variieren der Wellenlänge des genannten Ausgangslaserbündels (907) aufweist.

8. Tragbares Gerät mit einem System nach Anspruch 4, 5, 6 oder 7.

9. Mobiltelefon mit einem System nach Anspruch 4, 5, 6 oder 7.

10. Spieleinheit mit einem System nach Anspruch 4, 5, 6 oder 7.

## Revendications

1. Support d'informations (801) comprenant :
- une couche de données (802) qui est destinée à stocker un ensemble de données élémentaires,
- une couche (803) comprenant une série périodique d'ouvertures (804) qui sont positionnées en parallèle à ladite couche de données (802) pour générer une série de spots lumineux qui sont destinés à être appliqués à ladite couche de données (802), **caractérisé en ce que** la distance comprise entre la couche de données et la couche est égale à un multiple ou à un sous-multiple de la distance de Talbot.

2. Support d'informations selon la revendication 1, comprenant encore des zones adjacentes de données élémentaires (EDA1, EDA2 ...) qui sont destinées à stocker lesdites données élémentaires.

3. Support d'informations selon la revendication 1 ou selon la revendication 2, dans lequel la période (d) des ouvertures est un multiple de la (des) période(s) des zones de données élémentaires (EDA1, EDA2 ...).

4. Système de lecture d'un support d'informations ayant une couche de données et une couche (803) comprenant une série périodique d'ouvertures (804) qui sont positionnées en parallèle à ladite couche de données (802) pour générer une série de spots lumineux qui sont destinés à être appliqués à ladite couche de données (802), la distance comprise entre la couche de données et la couche étant égale à un multiple ou à un sous-multiple de la distance de Talbot, ledit système comprenant :
- une source lumineuse (906) pour générer un faisceau laser de sortie (907) qui est destiné à être appliqué à toute la surface de ladite couche, ledit faisceau laser de sortie ayant une section carrée ou rectangulaire bidimensionnelle,
- un détecteur (908) pour détecter des signaux lumineux de sortie qui sont générés à l'endroit de la sortie de ladite couche de données en réponse audit faisceau laser de sortie (907).

5. Système selon la revendication 4, comprenant encore un actionneur pour faire varier l'angle (α) dudit faisceau laser de sortie (907).

6. Système selon la revendication 4, comprenant encore un déphaseur (910) pour faire varier la phase dudit faisceau laser de sortie (907).

7. Système selon la revendication 4, 5, ou 6, dans lequel ladite source lumineuse (906) comprend un modulateur pour faire varier la longueur d'onde dudit faisceau laser de sortie (907).

8. Dispositif portable comprenant un système, tel que revendiqué dans la revendication 4, 5, 6 ou 7.

9. Téléphone mobile comprenant un système, tel que revendiqué dans la revendication 4, 5, 6 ou 7.

10. Unité de jeux comprenant un système, tel que revendiqué dans la revendication 4, 5, 6 ou 7.
